# FASCICULE DE BREVET EUROPEEN

(11) **EP 2 709 277 B1**
(45) Date de publication et mention de la délivrance du brevet: **12.08.2015**
(21) Numéro de dépôt: 13354033.6
(22) Date de dépôt: 13.09.2013
(51) Int. Cl.: H03K 19/21, G06F 9/38

(54) **Circuit asynchrone à écritures séquentielles**
Asynchroner Kreislauf mit sequenzieller Ausführung von Vorgängen
Asynchronous circuit with sequential writing

(30) Priorité: 13.09.2012 FR 1202446
(43) Date de publication de la demande: 19.03.2014
(73) Titulaire: Tiempo, F-38330 Montbonnot St-Martin (FR)
(72) Inventeur: Renaudin, Marc, F-38330 Biviers (FR); Fonkoua, Alain, F-38100 Grenoble (FR); Monnet, Yanick, F-38700 Le Sappey-en-Chartreuse (FR); Rjimati, Yassine, F-38170 Seyssinet (FR)
(74) Mandataire: Talbot, Alexandre

(56) Documents cités:
- US-A- 5 646 554
- US-A1- 2003 095 556
- US-B1- 6 486 700

## Description

### Domaine technique de l'invention

L'invention est relative à la conception de circuits asynchrones, et plus particulièrement à des circuits asynchrones modélisés selon un protocole de communication à deux phases et implémentés selon un protocole à quatre phases.

### État de la technique

A la différence d'un circuit synchrone, un circuit asynchrone comme décrit par exemple dans le document US 6,486,700 B1 n'utilise pas de signal d'horloge global pour synchroniser l'exécution de ses composants. Les composants du circuit asynchrone se synchronisent localement, en utilisant un protocole de communication de type requête et acquittement. Toute transmission d'information entre un composant émetteur et un composant récepteur doit être acquittée par le récepteur pour que l'émetteur puisse transmettre à nouveau.

Ces composants communiquent entre eux au travers de canaux. Chaque canal regroupe donc un chemin de requête et un chemin d'acquittement. En outre, ils échangent des données. Ces données sont communément codées pour intégrer directement l'information de validité que constitue la requête. Dans ce cas, chaque bit de donnée est codé sur au moins deux fils.

Il est également possible de n'utiliser qu'un seul fil par bit de donnée et de véhiculer l'information de validité indépendamment des données, par un fil distinct. Dans ce cas, la requête et les données sont des signaux distincts.

Le protocole de communication le plus utilisé est le protocole à quatre phases, appelé également protocole « retour à zéro » (« four-phase handshake » en anglais). Les différentes phases du protocole sont les suivantes :
- Phase 1 : l'émetteur envoie un signal de requête au récepteur ;
- Phase 2 : le récepteur détecte le signal de requête, effectue le traitement des données et génère un signal d'acquittement ;
- Phase 3 : l'émetteur détecte le signal d'acquittement et invalide le signal de requête ; et
- Phase 4 : le récepteur détecte l'état invalide du signal de requête et désactive le signal d'acquittement.

L'émetteur détecte l'état inactif du signal d'acquittement et peut alors émettre une nouvelle requête et de nouvelles données (si celles-ci sont disponibles), ce qui marque le début d'un nouveau cycle de communication.

Le protocole à deux phases, appelé également protocole « non retour à zéro » (« Half-handshake » en anglais), ne comprend que les deux premières phases. Comme précédemment, chaque changement du signal de requête est acquitté par le signal d'acquittement, et vis versa. Par contre, il n'y a pas de retour aux états invalides du signal de requête et du signal d'acquittement (phases 3 et 4).

Le protocole à deux phases implique moins de transitions. Un circuit qui le met en oeuvre devrait donc être plus rapide et plus économe en énergie. En pratique, cependant, le circuit est implémenté pour fonctionner avec le protocole quatre phases. En effet, il est plus simple d'implémenter le protocole à quatre phases car le nombre d'états possibles est restreint. Le protocole à deux phases reste avantageux pour décrire, puis simuler le comportement du circuit avant la synthèse, en raison de sa grande rapidité.

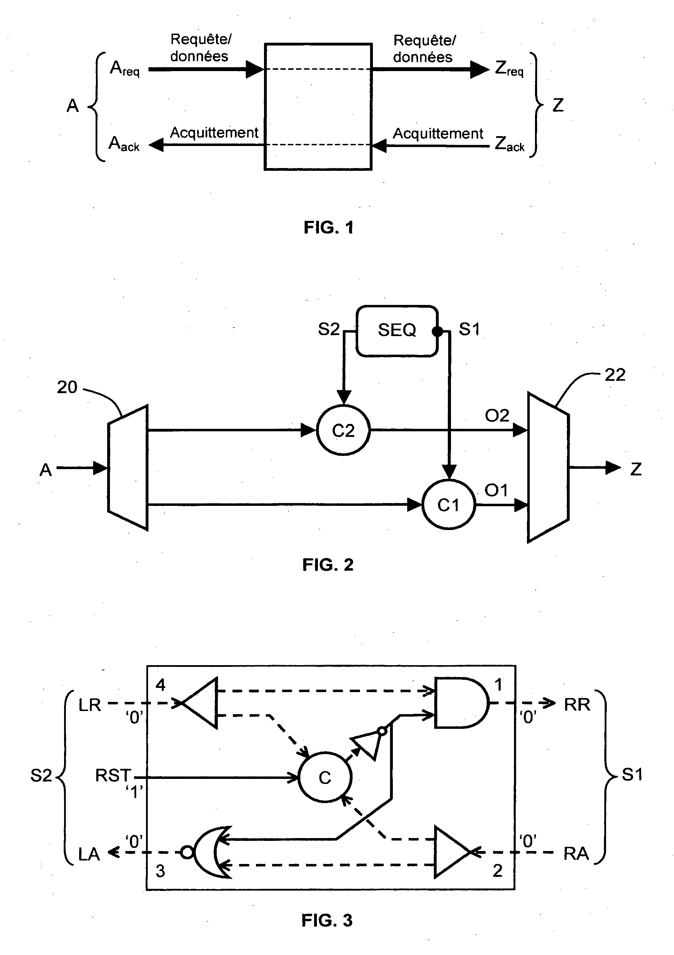

La figure 1 représente schématiquement un dispositif de rendez-vous entre canaux couramment employé dans les circuits asynchrones. Ce dispositif permet de transférer une information, par exemple d'un canal d'entrée A vers un canal de sortie Z. Le signal de requête et le signal d'acquittement du canal A sont notés respectivement A_{req} et A_{ack}. Le signal de requête et le signal d'acquittement du canal Z sont notés respectivement Z_{req} et Z_{ack}

Le dispositif de rendez-vous se comporte de la manière suivante : le canal A est libéré (et ainsi prêt à transmettre une nouvelle information) après seulement que l'information a été transmise au canal Z et que ce dernier a été relâché. Ce comportement peut être décrit simplement d'après un protocole à deux phases : la requête A_{req} du canal A est d'abord propagée sur le canal Z par le signal Z_{req}, puis l'acquittement Z_{ack} du canal Z se propage sur le canal A, en A_{ack}.

On constate donc, qu'en deux phases, la connexion (dite « biphasée ») peut se réduire à un simple fil (en traits pointillés sur la figure 1) connectant les fils des requêtes A_{req} et Z_{req} d'une part, et les fils des acquittements A_{acq} et Z_{acq} d'autre part. Autrement dit, A et Z décrivent le même canal.

Toutefois, lorsqu'on transpose une connexion biphasée de canaux en quatre phases lors de la synthèse, cette simplification peut conduire à un dysfonctionnement du circuit. Le circuit fonctionne correctement en deux phases lors de la simulation avant synthèse mais bloque lorsqu'on le simule en quatre phases après synthèse.

### Résumé de l'invention

On constate qu'il existe un besoin de connecter des canaux dans un circuit asynchrone en réduisant les risques de dysfonctionnement du circuit.

Plus particulièrement, on vise à améliorer le fonctionnement du circuit asynchrone lors du passage d'un modèle fonctionnel décrit en deux phases à un circuit physique implémenté en quatre phases.

L'invention tend à satisfaire ce besoin en prévoyant, dans un circuit asynchrone comprenant une pluralité de composants reliés par des canaux, chaque canal véhiculant un signal de requête et un signal d'acquittement, les éléments suivants :
- un canal d'entrée ;
- un opérateur de divergence connectant le canal d'entrée à une pluralité de canaux intermédiaires ;
- un opérateur de convergence regroupant les canaux intermédiaires en un seul canal de sortie ;
- un séquenceur principal comprenant une pluralité de canaux de commande activés séquentiellement, chaque canal intermédiaire étant couplé à un canal de commande ;
- un interrupteur disposé dans le chemin de requête de l'un des canaux intermédiaires et connecté au canal de commande activé en dernier, d'où il résulte que le signal de requête dudit canal intermédiaire est transmis vers le canal de sortie en dernier dans la séquence ;
- un circuit de mémorisation, disposé dans chacun des autres canaux intermédiaires, connecté au canal de commande associé et configuré pour transmettre le signal de requête du canal intermédiaire associé vers le canal de sortie ; et
- le circuit de mémorisation étant en outre configuré pour modifier l'état en sortie du canal intermédiaire associé, au moyen du séquenceur principal, sans que le canal d'entrée ne change d'état.

De préférence, l'interrupteur est formé d'une porte de Müller recevant en entrée le signal de requête du canal intermédiaire associé et un signal de requête du canal de commande associé.

Dans un premier mode de réalisation de l'invention, le circuit de mémorisation comporte une porte ET recevant en entrée le signal de requête du canal intermédiaire associé et un signal de requête du canal de commande associé.

Dans un deuxième mode de réalisation de l'invention, le circuit de mémorisation comporte une porte de Müller asymétrique munie d'une première entrée recevant le signal de requête du canal intermédiaire associé et d'une deuxième entrée recevant un signal de requête du canal de commande associé, la première entrée ne conditionnant qu'une seule des transitions de la porte de Müller.

Dans un troisième mode de réalisation de l'invention, le circuit de mémorisation comporte une porte de Müller recevant en entrée le signal de requête du canal intermédiaire associé et un signal de requête du canal de commande associé du séquenceur principal. Il comporte en outre un séquenceur secondaire muni d'un premier canal de commande couplé à la sortie du canal intermédiaire associé par l'intermédiaire de la porte de Müller et d'un second canal de commande couplé à l'entrée du canal intermédiaire associé.

Selon un développement de l'invention, le canal de commande du séquenceur principal activé en dernier peut recevoir soit un signal de requête d'un circuit de contrôle, soit un signal de requête du canal d'entrée, soit un signal d'acquittement du canal intermédiaire associé et un signal de réinitialisation du séquenceur

### Description sommaire des dessins

D'autres avantages et caractéristiques ressortiront plus clairement de la description qui va suivre de modes particuliers de réalisation donnés à titre d'exemples non limitatifs et illustrés à l'aide des dessins annexés, dans lesquels :
- la figure 1, précédemment décrite, est une représentation schématique d'une connexion de canaux dans un circuit asynchrone ;
- la figure 2 est un schéma synoptique d'un circuit asynchrone à écritures séquentielles entre un canal d'entrée et un canal de sortie, qui résulte en un dysfonctionnement ;
- les figures 3 à 7 représentent des étapes de fonctionnement d'un séquenceur utilisé dans le circuit de la figure 2 ;
- la figure 8 représente en détail le circuit à écritures séquentielles de la figure 2, à l'exception de l'opérateur de convergence ;
- la figure 9 représente un mode de mise en oeuvre de l'opérateur de convergence de la figure 2 ;
- les figures 10 et 11 représentent des étapes de fonctionnement du circuit de la figure 8, d'après un protocole de communication à quatre phases ;
- la figure 12 est un schéma synoptique d'un circuit asynchrone à écritures séquentielles modifié selon l'invention ;
- la figure 13 représente un premier mode de réalisation de circuit asynchrone à écritures séquentielles selon l'invention ;
- les figures 14 à 16 représentent des étapes de fonctionnement du circuit de la figure 13, d'après un protocole de communication à quatre phases ;
- la figure 17 représente un deuxième mode de réalisation de circuit asynchrone à écritures séquentielles selon l'invention ;
- la figure 18 représente un troisième mode de réalisation de circuit asynchrone à écritures séquentielles selon l'invention ;
- les figures 19 et 20 représentent des variantes de mise en oeuvre pour commander le séquenceur de la figure 18 ; et
- la figure 21 représente le circuit asynchrone à écritures séquentielles de la figure 18 lorsque les signaux de requête sont codés sur plusieurs fils.

### Description d'un mode de réalisation préféré de l'invention

Dans la description qui suit, la requête et l'acquittement désignent des signaux de contrôle locaux qui permettent la synchronisation entre deux composants d'un circuit asynchrone. Les fils véhiculant ces signaux forment un canal de communication entre les deux composants.

Le signal de requête peut éventuellement être associé aux données qui transitent entre les deux composants. Dans ce cas, la requête et les données forment un même signal, de plusieurs bits, chaque bit étant codé sur au moins deux fils (codage « double rail » par exemple). Autrement dit, le signal de requête n'est pas nécessairement véhiculé par un seul fil.

Les inventeurs ont remarqué qu'une connexion entre canaux, dont le comportement est décrit en deux phases, produit après synthèse un blocage du circuit lorsque la connexion met en oeuvre des écritures séquentielles. Dans l'exemple de la figure 1, cela revient à propager plusieurs fois la requête A_{req} du canal A vers le canal Z avant de relâcher le canal A. Ainsi, le canal A est lu une seule fois et le canal Z est écrit plusieurs fois.

La figure 2 est un schéma synoptique d'un circuit asynchrone à écritures séquentielles entre un canal d'entrée A et un canal de sortie Z. Des écritures séquentielles sur le canal Z impliquent que le canal d'entrée A diverge en une pluralité de chemins, puis que ces chemins convergent vers le canal de sortie Z sous le contrôle d'un séquenceur.

Le circuit comporte ainsi un opérateur de divergence 20, un opérateur de convergence 22 et un séquenceur SEQ. L'opérateur de divergence 20 distribue le canal d'entrée A en plusieurs canaux intermédiaires. Sur l'exemple de la figure 2, deux canaux intermédiaires O1 et O2 sont représentés. L'opérateur de convergence 22 connecte les canaux intermédiaires O1 et O2 au canal de sortie Z.

L'opérateur de divergence 20 peut être un composant qui duplique le canal d'entrée A en au moins deux canaux intermédiaires O1 et O2 de taille identique. Par exemple, si le canal d'entrée A est composé de *n*+1 fils ou rails (n fils pour la requête et 1 fil pour l'acquittement), les canaux O1 et O2 sont également constitués de *n*+1 fils.

Alternativement, l'opérateur de divergence 20 peut être configuré pour diviser le signal de requête à *n* fils du canal d'entrée A en *n* signaux intermédiaires à 1 fil (*n* ≥ 2). Chacun des signaux intermédiaires ainsi obtenus forme la requête d'un canal intermédiaire O1, O2 et chaque canal intermédiaire dispose en outre d'un fil d'acquittement.

Le circuit comporte également des interrupteurs C1, C2 situés dans les canaux intermédiaires. Plus précisément, chaque canal intermédiaire contient un interrupteur, entre les opérateurs 20 et 22. Les interrupteurs C1, C2 conditionnent les écritures successives du canal A vers le canal Z, en « ouvrant » ou « fermant » les canaux O1 et O2.

Les interrupteurs C1, C2 sont reliés au séquenceur SEQ, qui les contrôle. Le séquenceur comprend à cet effet un canal de commande S1, S2 par interrupteur. Il y a donc autant d'interrupteurs et de canaux de commande qu'il y a de canaux intermédiaires.

Dans l'exemple de la figure 2, l'interrupteur C1 est disposé dans le canal intermédiaire O1 et piloté par le canal de commande S1. L'interrupteur C2 est disposé dans le canal O2 et piloté par le canal S2.

Les canaux de commande S1 et S2 du séquenceur sont actifs l'un après l'autre. Le canal S1 est, par exemple, activé en premier dans la séquence d'écritures. L'information véhiculée dans le canal A est ainsi transmise au canal Z, d'abord par l'intermédiaire du canal O1, puis par l'intermédiaire du canal O2.

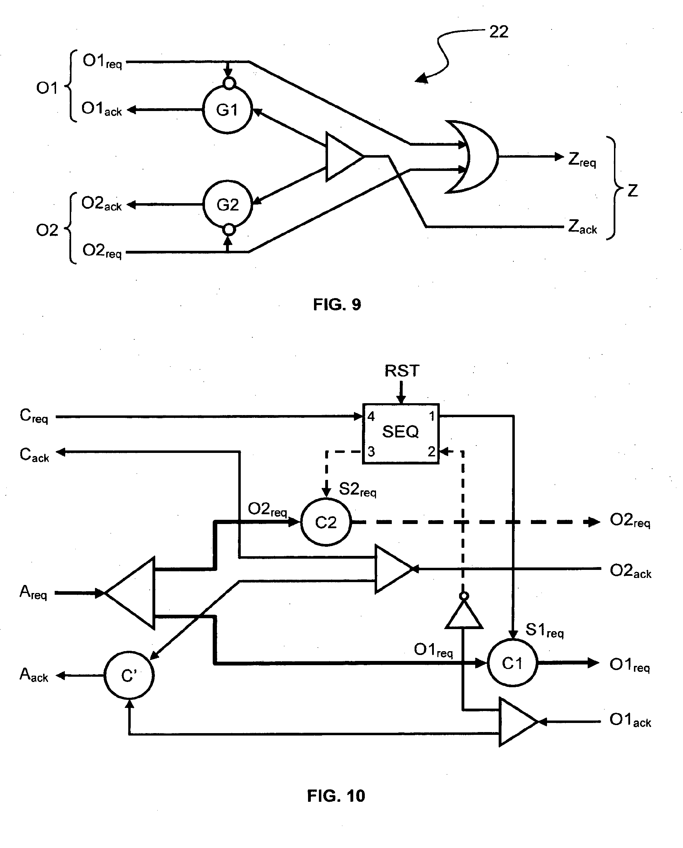

Chaque écriture sur le canal Z correspond à un cycle complet du protocole de communication. Par conséquent, plusieurs cycles de quatre phases devraient être mis en oeuvre sur le canal Z, avant même que le canal A ne termine son propre cycle. Toutefois, comme cela sera décrit en relation avec la figure 10, le fonctionnement en quatre phases du circuit à écritures séquentielles n'est pas celui escompté.

La figure 3 représente en détail un séquenceur à deux canaux de commande. Ce composant, utilisé dans le circuit de la figure 2, est néanmoins classique en électronique asynchrone. Hormis l'appellation des canaux de commande (S1, S2), il apparaît ici tel qu'il est habituellement représenté dans la littérature.

Le séquenceur comprend quatre entrées-sorties principales, référencées de 1 à 4, et une entrée RST de réinitialisation de la séquence. A droite, la sortie 1 et l'entrée 2 sont associées respectivement à un signal de requête RR et un signal d'acquittement RA. Ces deux signaux correspondent au canal S1 de la figure 2. La sortie 3 et l'entrée 4, à gauche, sont associées respectivement aux signaux d'acquittement LA et de requête LR et correspondent au canal S2.

Le séquenceur comprend en outre une porte de Müller C, appelée également porte « rendez-vous ». La sortie d'une porte de Müller recopie ses entrées lorsque celles-ci sont identiques. Lorsque les entrées diffèrent, la sortie reste dans son état logique précédent.

La porte C reçoit en entrée le signal d'acquittement RA du canal droit (entrée 2) et le signal de requête LR du canal gauche (entrée 4). Sa sortie est connectée à une entrée d'une porte « ET » d'une part, et à une entrée d'une porte « NON-OU » d'autre part, par l'intermédiaire d'un inverseur. La porte de Müller C reçoit en outre un signal de réinitialisation, en provenance de l'entrée RST du séquenceur. Ce signal est capable de forcer l'état en sortie de la porte C.

Par ailleurs, le signal LR est dupliqué vers une deuxième entrée de la porte « ET » tandis que le signal RA est dupliqué vers une deuxième entrée de la porte « NON-OU ». Les signaux en sortie des portes « ET » et « NON-OU » forment respectivement les signaux de requête RR du canal droit et d'acquittement LA du canal gauche, aux sorties 1 et 3 du séquenceur.

Les figures 3 à 7 illustrent des étapes du fonctionnement du séquenceur, pris isolément. Pour faciliter la compréhension, on a représenté un signal à l'état bas (niveau logique '0') par un fil en traits pointillés et un signal à l'état haut (niveau logique '1') par un fil en trait plein.

Concernant le séquenceur, on a adopté la convention suivante : les signaux RR, RA, LA et LR aux entrées-sorties 1 à 4 sont actifs à l'état haut et le signal RST est actif à l'état bas. Autrement dit, le séquenceur est dans sa phase d'initialisation tant que le signal RST est à '0'.

Après initialisation, tous les signaux sont inactifs. Les signaux RR, RA, LA et LR sont à '0' tandis que le signal RST est à '1'. Le signal en sortie de la porte C est à '0'. Cet état initial est représenté sur la figure 3.

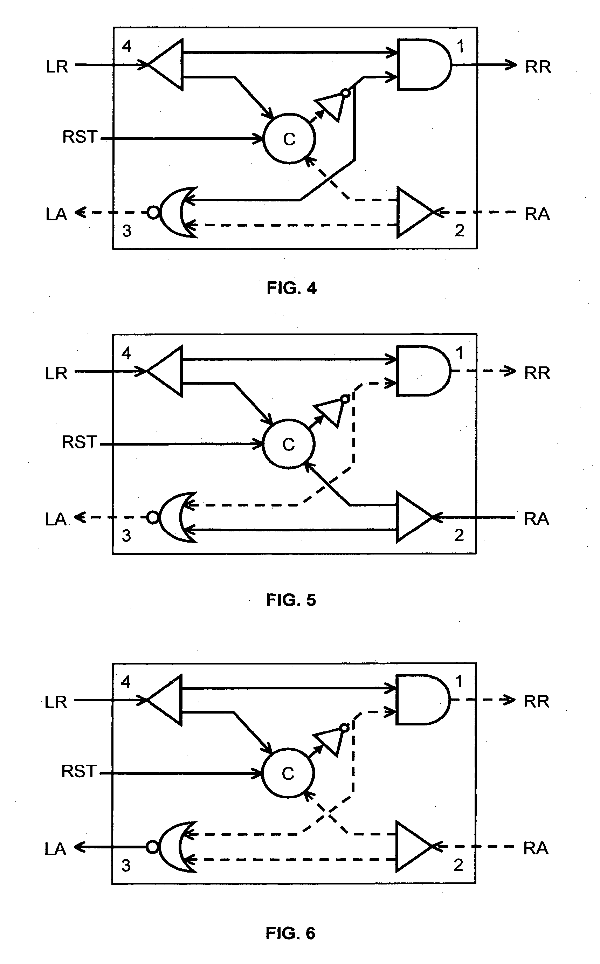

Lors d'une première étape illustrée à la figure 4, le signal de requête LR du canal gauche passe à l'état haut ('1'), ce qui provoque le basculement de la porte « ET ». Le signal de requête RR du canal droit, en sortie de la porte « ET », passe alors à '1'. La porte C ne bascule pas car ses entrées LR et RA diffèrent (LR = '1' et RA = '0').

A l'étape suivante (Fig. 5), le signal d'acquittement RA du canal droit passe à '1' en réponse à la précédente requête RR. Cela a pour conséquence le basculement de la porte C puisque ses entrées LR et RA sont désormais toutes à '1'. Le signal en sortie de la porte C passe de '0' à '1', puis est inversé en entrée de la porte « ET ». La requête droite RR retourne alors à l'état bas ('0'), invalide.

En figure 6, l'acquittement droit RA est désactivé, il repasse à '0'. La porte C ne bascule pas, car ses entrées diffèrent. Cela provoque par contre le basculement de la porte « NON-OU », dont les entrées sont toutes les deux à '0'. Le signal d'acquittement LA est alors activé (LA = '1').

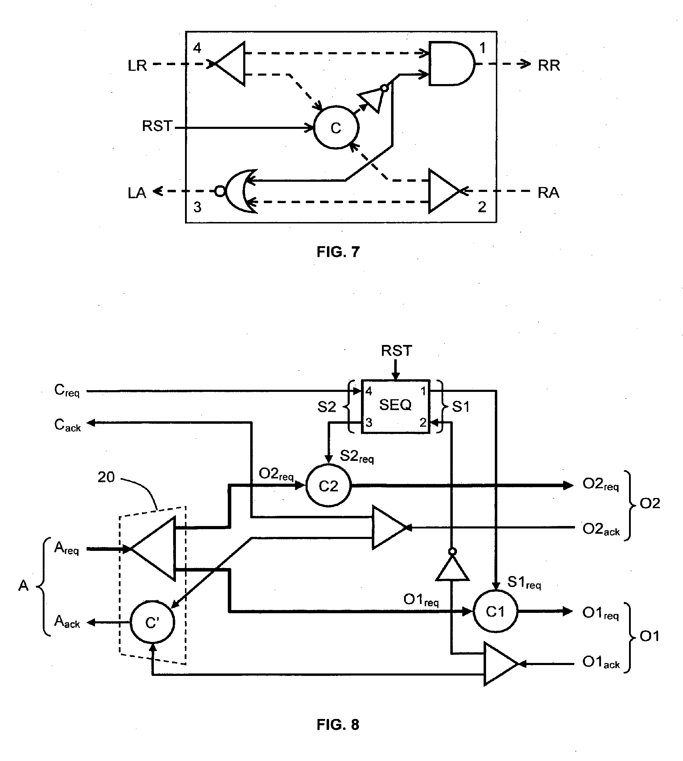

Enfin, lors d'une dernière étape (Fig. 7), la requête gauche LR est invalidée (LR = '0') suite au précèdent acquittement LA. La porte C bascule à nouveau. Le signal en sortie de la porte C change d'état, de '1' à '0', et ce changement est répercuté en entrée de la porte « NON-OU » après inversion. Il en résulte que l'acquittement gauche LA est désactivé, c'est-à-dire mis à '0'. Le séquenceur revient dans son état initial (Fig.3), avant de commencer un nouveau cycle.

La séquence se résume ainsi :
LR = '1' ⇒ RR = '1' ⇒ RA = '1' ⇒ RR = '0' ⇒ RA = '0' ⇒ LA = '1' ⇒ LR = '0' ⇒ LA = '0'

Le protocole à quatre phases est d'abord initié sur le canal gauche S2 du séquenceur, par le signal LR. Puis, les quatre phases s'enchainent sur le canal droit S1, par les signaux RR et RA qui passent successivement de '0' à '1' et de '1' à '0'. Enfin, les trois dernières phases du protocole sur le canal S2 sont accomplies.

La figure 8 est une vue détaillée d'une partie du circuit à écritures séquentielles de la figure 2. Les canaux A, O1, O2, S1 et S2 ont été éclatés pour faire apparaître les circuits de requête et d'acquittement. Les signaux de chaque canal sont nommés par la lettre du canal, suivi de l'abréviation « req » pour un signal de requête ou de l'abréviation « ack » pour un signal d'acquittement.

On retrouve sur la figure 8 le séquenceur SEQ, l'opérateur de divergence 20 et les interrupteurs C1, C2. L'opérateur 20 reçoit en entrée un signal de requête A_{req} du canal d'entrée. Les interrupteurs C1 et C2 sont placés dans les canaux intermédiaires, et plus particulièrement dans le chemin des requêtes O1_{req} et O2_{req}, qui sont issues de l'opérateur 20.

Les chemins de la requête O1_{req} et de l'acquittement O1_{ack} forment le canal de communication intermédiaire O1 qui s'étire de l'opérateur de divergence 20 jusqu'à l'opérateur de convergence (non représenté sur la figure 8). En particulier, la requête O1_{req} se propage de l'opérateur 20 jusqu'au canal de sortie, en traversant l'interrupteur C1. Il en est de même des signaux de requête O2_{req} et d'acquittement O2_{ack}, pour le canal O2 et l'interrupteur C2.

Par commodité, le signal de requête avant l'interrupteur et le signal de requête après l'interrupteur portent le même nom : O1_{req} dans le canal 01 et O2_{req} dans le canal 02 (Fig.8).

Comparé à la figure 2, on distingue désormais les quatre entrées-sorties du séquenceur. Pour rappel, les entrées-sorties 1 et 2 correspondent au canal de commande S1 du séquenceur, couplé au canal intermédiaire 01, et les entrées-sorties 3 et 4 correspondent au canal de commande S2, couplé au canal intermédiaire O2.

Les interrupteurs C1 et C2 sont, de préférence, formés de portes de Müller à deux entrées. Chaque porte de Müller reçoit en entrée un signal de requête du canal intermédiaire dans lequel elle est disposée, et un signal de requête du canal de commande couplé à ce canal intermédiaire. La porte C1 reçoit par exemple la requête O1_{req} du canal intermédiaire 01 et la requête S1_{req} du canal de commande S1. La porte C2 a pour entrées la requête O2_{req} du canal intermédiaire O2 et la requête S2_{req} du canal de commande S2.

Les requêtes S1_{req} et S2_{req} sont issues respectivement des sorties 1 et 3 du séquenceur. L'entrée 2 reçoit un signal d'acquittement O1_{ack} du canal O1, après son passage dans un inverseur. L'entrée 4 est connectée à un circuit auxiliaire de contrôle (non représenté) lui fournissant un signal de requête C_{req}.

Le circuit auxiliaire de contrôle permet d'initier une séquence d'écritures. En effet, comme cela a été décrit précédemment, la première phase de fonctionnement de séquenceur démarre sur le canal gauche, en entrée 4 (LR = '1' ; Fig.4).

Le circuit auxiliaire de contrôle est acquitté par l'intermédiaire d'un signal C_{ack} qui marque la fin de la séquence d'écritures. Or, dans cet exemple, l'information véhiculée par le canal intermédiaire O2 est écrite en dernier sur le canal de sortie. Cela explique pourquoi le signal C_{ack} correspond en fait au signal d'acquittement O2_{ack} du deuxième (et dernier) canal intermédiaire.

Les signaux d'acquittement O1_{ack} et O2_{ack} sont par ailleurs dupliqués et dirigés en entrée d'une porte de Müller C'. Le signal en sortie de la porte C' constitue le signal d'acquittement A_{ack} du canal d'entrée. Puisque la porte de Müller C' ne bascule que si ses entrées sont égales, le signal d'acquittement A_{ack} n'est généré que lorsque les signaux d'acquittement O1_{ack} et O2_{ack} ont été générés (O1_{ack} = O2_{ack} = '1'). En d'autres termes, le canal A ne peut être relâché qu'après le relâchement du canal O1 et du canal O2. La sémantique d'une connexion de canaux devrait donc être respectée.

Dans l'exemple de la figure 8, l'opérateur de divergence 20 comprend un opérateur de duplication (i.e. une fourche) dans le chemin de requête et la porte de Müller C' dans le chemin d'acquittement.

La figure 9 est un exemple classique de réalisation de l'opérateur de convergence 22 (Fig. 2), écarté de la figure 8 pour plus de lisibilité.

L'opérateur de convergence 22 fusionne les deux canaux intermédiaires O1 et O2 en un seul canal de sortie Z. Il comprend, dans le chemin de requête, une porte « OU » ayant pour entrées les signaux O1_{req} et O2_{req} et pour sortie le signal Z_{req} du canal de sortie.

Deux portes de Müller G1 et G2 sont disposées dans le chemin d'acquittement, pour former les signaux O1_{ack} ou O2_{ack} à partir du signal Z_{ack}. Les signaux O1_{req} et O2_{req} étant mutuellement exclusifs, les signaux O1_{ack} et O2_{ack} doivent l'être également. Pour cela, le signal O1_{req} est rebouclé en entrée de la porte de Müller G1 et le signal O2_{req} est rebouclé en entrée de la porte de Müller G2.

Les portes de Müller G1 et G2 sont équipées chacune d'un inverseur, sur leur entrée recevant le signal O1_{req} ou O2_{req}. Ainsi, la porte G1 a pour signaux d'entrée le signal Z_{ack} et une copie inversée du signal O1_{req} tandis que la porte G2 reçoit en entrée le signal Z_{ack} et une copie inversée du signal O2_{req}.

Maintenant que les éléments du circuit à écritures séquentielles de la figure 8 ont été introduits, on peut mettre en évidence le problème de blocage rencontré avec ce circuit, en décrivant brièvement son fonctionnement d'après un protocole de communication à quatre phases.

Par convention, on considère ci-après que les signaux de requête A_{req}, O1_{req}, O2_{req} et C_{req} sont actifs à l'état haut et que les signaux d'acquittement A_{ack}, O1_{ack}, O2_{ack} et C_{ack} sont actifs à l'état bas. Parce que cette convention diffère de celle choisie pour décrire le fonctionnement interne du séquenceur, un inverseur est disposé dans le chemin du signal d'acquittement O1_{ack}, en entrée 2 du séquenceur SEQ (Fig. 8).

A l'état initial, tous les signaux du circuit sont au niveau logique '0', exceptés les signaux d'acquittement O1_{ack}, O2_{ack}, C_{ack} et A_{ack} qui sont au niveau logique '1'.

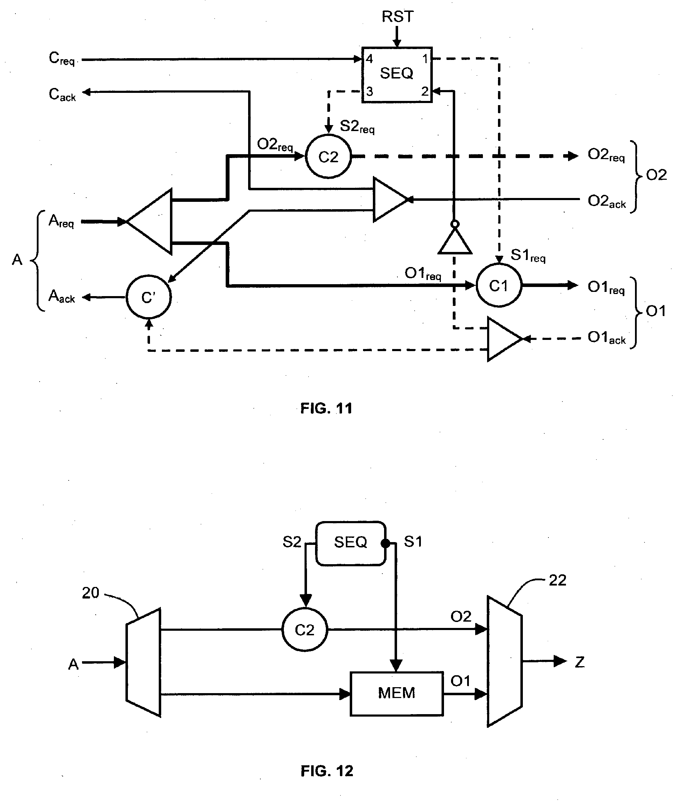

Les figures 10 et 11 représentent deux étapes ultérieures de fonctionnement du circuit de la figure 8. Les niveaux logiques '0' et '1' sont représentés comme précédemment, respectivement par des flèches en traits pointillés et en trait plein.

A l'étape de la figure 10, le séquenceur est activé par le signal C_{req}, porté à '1' par le circuit de contrôle. Il en résulte que le signal S1_{req}, en sortie 1 du séquenceur, passe également à '1' (cf. Fig.4). Simultanément, la requête A_{req} du canal d'entrée est activée (A_{req} = '1') et se propage dans les canaux intermédiaires en O1_{req} et O2_{req}, jusqu'aux portes C1 et C2.

Les entrées de la porte de Müller C1 sont toutes les deux à '1'. Par conséquent, elle autorise le passage de la requête O1_{req} vers l'opérateur de convergence et le canal de sortie. La requête O2_{req} est pour l'instant bloquée à la porte C2.

A la figure 11, l'acquittement O1_{ack} passe de son état initial '1' à l'état actif '0', ce qui signifie que la requête O1_{req} a été correctement transmise au canal de sortie. L'acquittement O1_{ack} est, d'une part, inversé (O̅1̅_̅{̅a̅c̅k̅}̅ = '1') et dirigé vers l'entrée 2 du séquenceur. Cela permet d'engager la deuxième phase de fonctionnement du séquenceur, celle où le signal S1_{req} retombe à '0' (Fig.5). D'autre part, le signal d'acquittement O1_{ack} = '0' est propagé en entrée de la porte C'.

En résumé, les deux premières phases du protocole de communication sont accomplies sur le premier canal intermédiaire O1 (O1_{req} = '1' et O1_{ack} = '0').

Le blocage du circuit intervient à cet instant et se situe au niveau de la porte C'. Celle-ci ne bascule pas, car ses entrées O1_{ack} et O2_{ack} diffèrent. L'acquittement A_{ack} en sortie de la porte C' n'est donc pas généré. Il reste à '0'. Dès lors, les troisième et quatrième phases du protocole ne peuvent être accomplies sur le canal 01 (respectivement O1_{req} = '1' et O1_{ack} = '1'), car cela nécessite une transition du canal d'entrée A.

Il faudrait pour cela que l'acquittement O2_{ack} passe également à '0'. Cela est rendu impossible par le séquenceur SEQ, qui exige qu'on exécute d'abord les quatre phases sur le canal O1 (plus exactement sur le canal de commande S1 qui est couplé au canal O1) avant de poursuivre le protocole sur le canal O2 (via le canal de commande S2).

Pour pallier à ce problème de blocage de la porte C', on constate qu'il faut forcer la transition logique dans le canal intermédiaire O1 pour passer de la deuxième phase à la troisième du protocole.

On a pour cela introduit dans le canal intermédiaire O1 un circuit de mémorisation capable de modifier l'état en sortie du canal O1, à l'aide du séquenceur SEQ, sans toutefois que le canal d'entrée A ne change d'état.

La figure 12 est un schéma synoptique d'un circuit à écritures séquentielles remédiant au problème de blocage décrit précédemment. Ce schéma reprend les éléments du circuit de la figure 2, à l'exception de l'interrupteur C1 qui est remplacé par un circuit de mémorisation MEM.

Le circuit MEM est disposé dans le canal intermédiaire O1, premier dans la séquence d'écriture imposée par le séquenceur SEQ. Le canal intermédiaire O2, dont le signal de requête est transmis en dernier vers le canal de sortie, conserve son interrupteur C2. Celui-ci est, de préférence, formé d'une porte de Müller à deux entrées, comme expliqué précédemment en relation avec la figure 8.

Comme l'interrupteur C1 de la figure 2, le circuit MEM est connecté au séquenceur SEQ par le biais du canal de commande S1. En effet, il doit à certains moments ouvrir le canal O1 et permettre le transfert du canal A vers le canal Z. La fonction première de ce circuit reste donc celle d'un interrupteur.

Le circuit MEM est en outre capable de terminer le protocole de communication sur le canal intermédiaire O1 avant d'acquitter le canal d'entrée A. En d'autres termes, il met en attente l'acquittement du canal d'entrée A, c'est pourquoi il peut être aussi qualifié de mémoire.

Or, c'est justement le rôle d'un séquenceur à deux canaux de commande que d'effectuer les quatre phases du protocole d'un côté, avant de poursuivre le protocole de l'autre côté.

Ainsi, il est prévu dans un premier mode de réalisation, d'utiliser un deuxième séquenceur, en plus du séquenceur SEQ. Pour les distinguer, le séquenceur SEQ est ci-après qualifié de « principal », car il commande le comportement global du circuit, c'est-à-dire les écritures successives sur le canal de sortie Z.

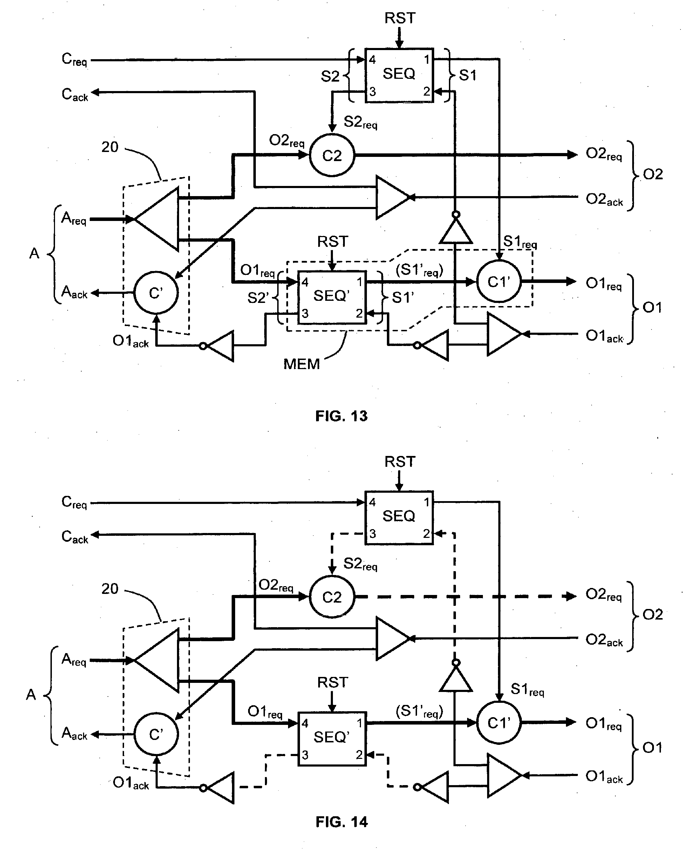

La figure 13 est une vue détaillée du circuit à écritures séquentielles dans ce premier mode de réalisation. Comme pour la figure 8, on a représenté seulement une partie du circuit pour plus de lisibilité.

Le circuit de mémorisation comporte, dans ce mode de réalisation, un séquenceur additionnel SEQ' dont le fonctionnement est identique à celui du séquenceur principal SEQ. Le séquenceur SEQ' dispose de quatre entrées-sorties, à l'image du séquenceur SEQ. Les deux premières (entrées-sorties 1 et 2) forment un premier canal de commande S1', à droite. Les deux autres (entrées-sorties 3 et 4) forment un second canal de commande S2', à gauche.

Le séquenceur SEQ' est disposé dans le canal intermédiaire O1, entre l'opérateur de divergence 20 et l'opérateur de convergence (non représenté). En quelque sorte, il coupe le canal intermédiaire O1 en deux parties, l'une à droite du séquenceur SEQ', l'autre à gauche. On peut donc désormais distinguer les signaux de requête et d'acquittement en entrée du canal (à gauche du séquenceur SEQ') et les signaux de requête et d'acquittement en sortie du canal (à droite du séquenceur SEQ'). L'entrée et la sortie du canal intermédiaire O1 sont définies par rapport au sens de propagation de la requête (de A vers Z sur la figure 12).

Cette distinction est utilisée ci-après car les états logiques de la requête et de l'acquittement varient selon leur position dans le canal.

Ainsi, le canal de commande S1' du séquenceur SEQ' (à droite) est couplé à la sortie du canal intermédiaire O1 (en entrée de l'opérateur de convergence) tandis que son canal de commande S2' (à gauche) est couplé à l'entrée du canal intermédiaire O1 (en sortie de l'opérateur de divergence 20).

Le circuit de mémorisation comporte en outre une porte de Müller C1' disposée également dans le canal intermédiaire O1, pour assurer l'ouverture ou la fermeture de ce canal. Plus particulièrement, la porte C1' est disposée dans le chemin de la requête O1_{req} et commandée par le canal S1 du séquenceur principal SEQ, tout comme la porte C1 des figures 8, 10 et 11.

Depuis l'opérateur 20 jusqu'à l'opérateur de convergence, le signal de requête O1_{req} du premier canal intermédiaire parcoure le chemin suivant: il traverse le séquenceur SEQ', en y entrant par l'entrée 4 et ressortant par la sortie 1, puis traverse la porte C1' lorsque le séquenceur principal SEQ le permet (en fonction du signal S1_{req} en sortie de la borne 1 du séquenceur SEQ).

Comme la porte C1' est connectée à l'entrée 1 du séquenceur secondaire SEQ', on peut aussi considérer qu'elle reçoit en entrée un signal de requête S1'_{req} du canal S1', en plus du signal de requête S1_{req} du séquenceur principal SEQ.

Le signal d'acquittement O1_{ack} parcourt sensiblement le chemin inverse. Il traverse le séquenceur SEQ', en entrant par l'entrée 2 et en sortant par la sortie 3, puis rejoint l'acquittement O2_{ack} du deuxième canal intermédiaire en entrée de la porte de Müller C'.

Selon les conventions de signaux utilisées pour le séquenceur et le signal d'acquittement O1_{ack}, deux inverseurs peuvent être disposés dans le chemin du signal O1_{ack}, l'un à l'entrée 2 du séquenceur SEQ' et l'autre en sortie 3 du séquenceur SEQ'.

L'agencement des canaux O2, S1, S2, ainsi que du canal de contrôle correspondant aux signaux C_{req} et C_{ack}, est par ailleurs identique à celui de la figure 8.

Lorsqu'on décrit le fonctionnement en quatre phases du circuit de la figure 13, en reprenant notamment les étapes des figures 10 et 11, on constate que le blocage ne se produit plus.

Les figures 14 à 16 illustrent des étapes de fonctionnement après initialisation d'un circuit à écritures séquentielles intégrant un séquenceur additionnel SEQ'. L'état initial de ce séquenceur est identique à celui du séquenceur principal SEQ (cf. Fig.3).

A la figure 14, le circuit auxiliaire de contrôle porte le signal C_{req} à '1', ce qui initie la séquence d'écritures. Le signal S1_{req} en entrée 1 du séquenceur SEQ passe alors à '1'. Par ailleurs, la requête A_{req} du canal d'entrée est activée (A_{req} = '1') et se propage en aval du duplicateur 20, en entrée 4 du séquenceur SEQ' dans le canal O1 et jusqu'à la porte C2 dans le canal O2.

Comme le séquenceur SEQ' se comporte de la même manière que le séquenceur principal, le signal S1'_{req} en entrée 1 du séquenceur SEQ' passe également à '1'. Ainsi, les deux entrées de la porte C1' valent '1' et la requête A_{req} = O1_{req} = '1' est propagée jusqu'au canal de sortie. La première phase du protocole s'est donc achevée dans le canal O1, aussi bien du côté gauche de séquenceur SEQ' (entrée 4) que du côté droit (sortie 1).

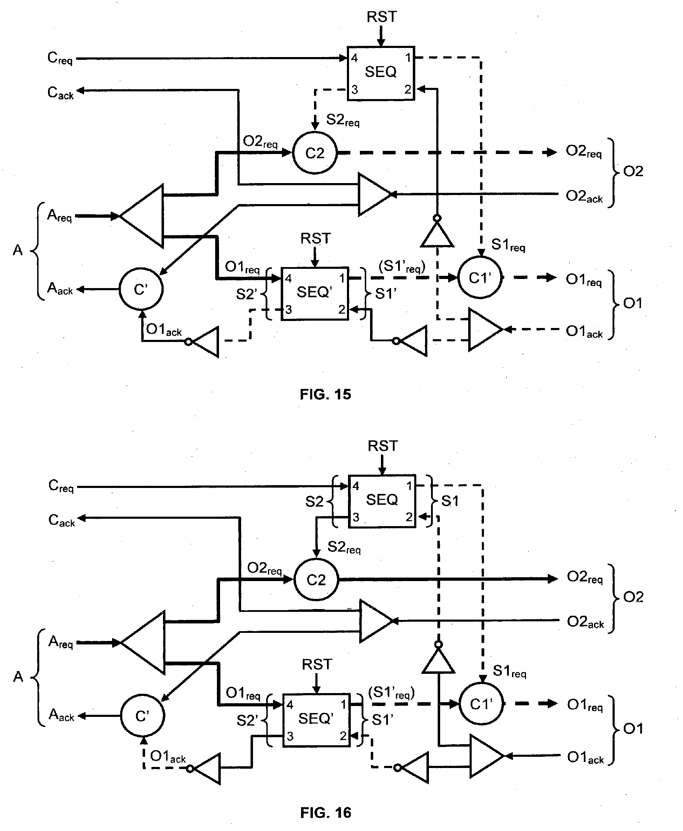

A l'étape suivante (Fig. 15), le signal O1_{ack} en sortie du canal 01 change d'état (de '1' vers '0') pour acquitter la bonne réception de la requête A_{ack} sur le canal de sortie. Cela correspond à la deuxième phase du protocole. L'acquittement O1_{ack} est inversé (O̅1̅_̅{̅a̅c̅k̅}̅ = '1') et dirigé en entrée 2 de chaque séquenceur.

A cet instant, le séquenceur SEQ' joue le rôle de tampon et ne propage pas l'acquittement O1_{ack} situé à son entrée 2 vers le canal A. Il commande au contraire une transition de son signal de requête droit S1'_{req}, de '1' vers '0', qui est répercutée en entrée de la porte C1'.

Le séquenceur principal SEQ se comporte de la même manière. Le signal de requête droit S1_{req} passe également à '0' (Fig. 6). Les deux entrées de la porte C1' valant '0', le signal O1_{req} = '0' est propagé vers le canal de sortie, ce qui correspond à la troisième phase du protocole en sortie du canal O1.

En entrée du canal O1, c'est-à-dire sur le canal gauche S2' du séquenceur SEQ', rien ne bouge car le canal de commande S1' est prioritaire devant le canal de commande S2'. Par conséquent, le signal d'acquittement A_{ack} du canal d'entrée n'est pas généré et la requête A_{req} n'est pas modifiée.

L'étape de la figure 16 correspond à la quatrième et dernière phase du protocole en sortie du canal O1. Le signal O1_{ack} repasse à son état initial '1' pour acquitter le précédent changement du signal O1_{req}. Cet état inactif du signal O1_{ack} est propagé en entrée 2 des deux séquenceurs. Cela correspond donc également à une quatrième phase de protocole dans les canaux S1 et S1'.

Or, comme décrit précédemment en relation avec la figure 6, la quatrième phase sur un canal droit d'un séquenceur est automatiquement suivie de la deuxième phase sur le canal gauche. Ainsi, les signaux en sortie 3 des séquenceurs SEQ et SEQ' changent d'état, en passant de leur état initial '0' à '1'.

Il s'en suit que la requête A_{req} = '1' se propage une deuxième fois vers le canal de sortie, par le canal intermédiaire O2 (la porte de Müller C2 étant devenue passante car O2_{req} = S2_{req} = '1'), et que le signal d'acquittement O1_{ack} = '0' remonte jusqu'à la porte C'.

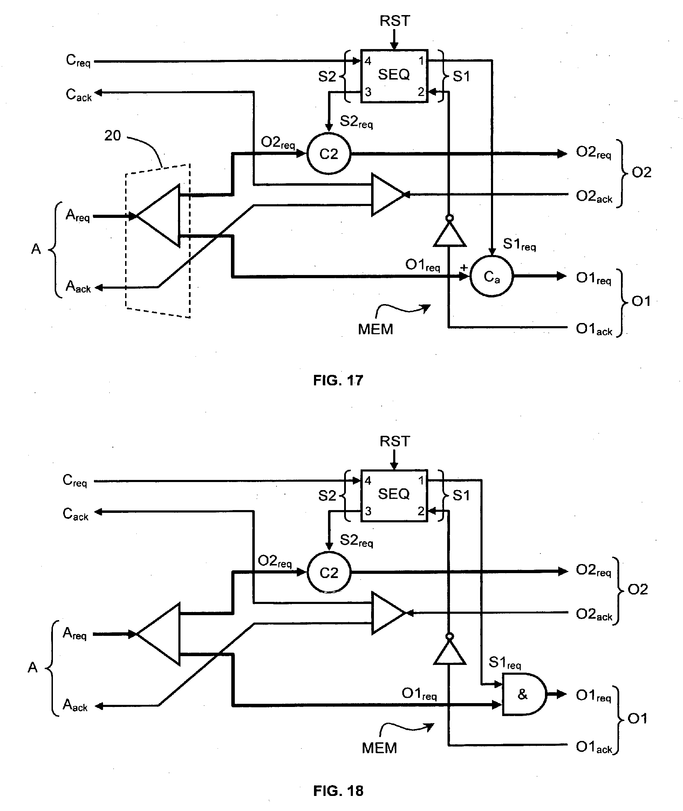

A l'étape encore suivante (non représentée), l'acquittement O2_{ack} du deuxième canal intermédiaire passera à '0' et les deux entrées (O1_{ack} et O2_{ack}) de la porte C' auront les mêmes valeurs. Par conséquent, l'acquittement A_{ack} sera généré (A_{ack} = '0') sans qu'il n'y ait eu de blocage. La figure 17 représente un deuxième mode de réalisation de circuit à écritures séquentielles, dont le fonctionnement est garanti lorsqu'on le simule en quatre phases.

Le circuit de mémorisation comporte ici une porte de Müller asymétrique Cₐ. La porte Cₐ est munie d'une première entrée recevant le signal de requête O1_{req} du premier canal intermédiaire et une deuxième entrée recevant le signal de requête S1_{req} du séquenceur principal SEQ.

Une porte de Müller asymétrique est une porte de Müller dont une entrée ne conditionne qu'une seule des transitions de la porte. Cette entrée (appelée ci-après asymétrique) est classiquement repérée par un « + » lorsqu'il s'agit de la transition montante ('0' vers '1') ou par un « - » lorsqu'il s'agit de la transition descendante ('1' vers '0').

Autrement dit, pour la transition opposée, l'autre entrée suffit à faire basculer la porte et la valeur de la sortie ne dépend que de la valeur de cette entrée.

Sur la figure 17, l'entrée asymétrique est celle recevant le signal de requête O1_{req} et la transition en question est une transition montante.

Ainsi, le signal en sortie de la porte Cₐ peut passer de '1' à '0' sans qu'il n'y ait besoin de modifier le signal de requête O1_{req}. Cela veut dire que le séquenceur SEQ va commander à lui seul le basculement de la porte Cₐ et accomplir la troisième phase du protocole en sortie de canal O1, c'est-à-dire le passage du signal O1_{req} de '1' à '0'.

On remplit bien la fonction du circuit de mémorisation, car la porte Cₐ est capable de modifier l'état en sortie du canal intermédiaire sans que le canal d'entrée ne change d'état.

Il n'est plus nécessaire de retourner le signal d'acquittement O1_{ack} du canal intermédiaire vers le canal d'entrée A, car la transition descendante de la requête A_{req} n'est plus requise. L'acquittement O1_{ack} est, par contre, toujours connecté à l'entrée 2 du séquenceur SEQ, par l'intermédiaire de l'inverseur (deuxième et quatrième phases du protocole sur O1 et S1).

Le circuit ne comporte donc pas, dans ce mode de réalisation, de porte de Müller regroupant les signaux d'acquittement O1_{ack} et O2_{ack}. L'acquittement du canal d'entrée A_{ack} n'est formé que du signal d'acquittement O2_{ack} du deuxième et dernier canal intermédiaire O2. En effet, il n'est plus nécessaire de vérifier l'acquittement O1_{ack} pour relâcher le canal d'entrée A, car, désormais, on a la certitude que le protocole s'est correctement déroulé sur le canal O1. L'acquittement du dernier canal intermédiaire O2 garantit que la séquence d'écriture est respectée.

L'opérateur de divergence 20 se résume alors, dans ce mode de réalisation, à une fourche dupliquant le signal A_{req} dans le chemin de requête et à un simple fil connectant les signaux O2_{ack} et A_{ack} dans le chemin d'acquittement.

Ce circuit asynchrone est plus simple à mettre en oeuvre que le circuit de la figure 13, car il contient moins de portes logiques. Il est également plus rapide et moins gourmand en énergie.

Sur la figure 17, on constate que la transition montante du signal en sortie de la porte Cₐ requiert que ces entrées O1_{req} et S1_{req} soient à '1'. Par contre, la transition descendante n'en requiert qu'une seule à '0' (S1_{req}). Ce comportement caractérise également une porte « ET ». Ainsi, dans un troisième mode de réalisation de l'invention, on remplace la porte de Müller asymétrique Cₐ du circuit de la figure 17 par une porte « ET ».

La figure 18 représente ce troisième mode de réalisation de circuit à écritures séquentielles, encore plus simplifié.

Le circuit de mémorisation comporte donc une porte « ET » à deux entrées. Elle est repérée par le symbole & sur la figure 18. Une entrée de la porte & est connectée à la sortie 1 du séquenceur principal SEQ et reçoit le signal de requête droit S1_{req}. L'autre entrée est connectée à une sortie de l'opérateur 20 et reçoit en entrée le signal de requête O1_{req} du premier canal intermédiaire qui en est issu.

Comme la porte de Müller asymétrique, la porte & permet de verrouiller ou déverrouiller le canal intermédiaire O1. En outre, elle autorise une transition de son signal de sortie, à partir d'une seule entrée. A nouveau, avec un tel circuit de mémorisation, on peut accomplir les quatre phases du protocole en bout de canal O1, et plus spécialement les troisième et quatrième phases, sans requérir un changement du canal d'entrée A.

En pratique, un circuit asynchrone met en oeuvre un grand nombre de connexions de canaux. Or, seulement certaines d'entre elles concernent des écritures séquentielles. Les solutions décrites ci-dessus ne pourront être appliquées qu'aux connexions à écritures séquentielles. Lors de la synthèse, les autres connexions peuvent êtres traitées plus simplement, par exemple en les considérant comme un seul fil.

Ainsi, les circuits des figures 12 à 18 ne représentent qu'une partie d'un circuit asynchrone bien plus vaste. Le circuit asynchrone comprend de nombreux composants ou opérateurs, connectés également par des canaux. Ces composants sont notamment situés en amont du canal d'entrée A et en aval du canal de sortie Z.

Il peut également y avoir des opérateurs asynchrones dans les canaux intermédiaires O1 et O2, par exemple si l'on souhaite réaliser une opération sur les requêtes (associées ou non aux données) de ces canaux intermédiaires.

Dans les modes de réalisation des figures 13, 17 et 18, la séquence d'écritures est commandée par un circuit auxiliaire de contrôle. En activant le signal de requête C_{req}, le circuit auxiliaire de contrôle amorce le fonctionnement du séquenceur SEQ. Le séquenceur SEQ met en oeuvre les différentes phases du protocole, d'abord sur les canaux S1 et O1 pour la première écriture, puis sur les canaux S2 et O2 pour la deuxième écriture. La fin de la séquence est signalée au circuit de contrôle par le retour à l'état inactif du signal d'acquittement O2_{ack}, c'est-à-dire le signal d'acquittement du dernier canal à écrire. Une nouvelle séquence d'écriture ne peut être engagée que par le circuit auxiliaire de contrôle.

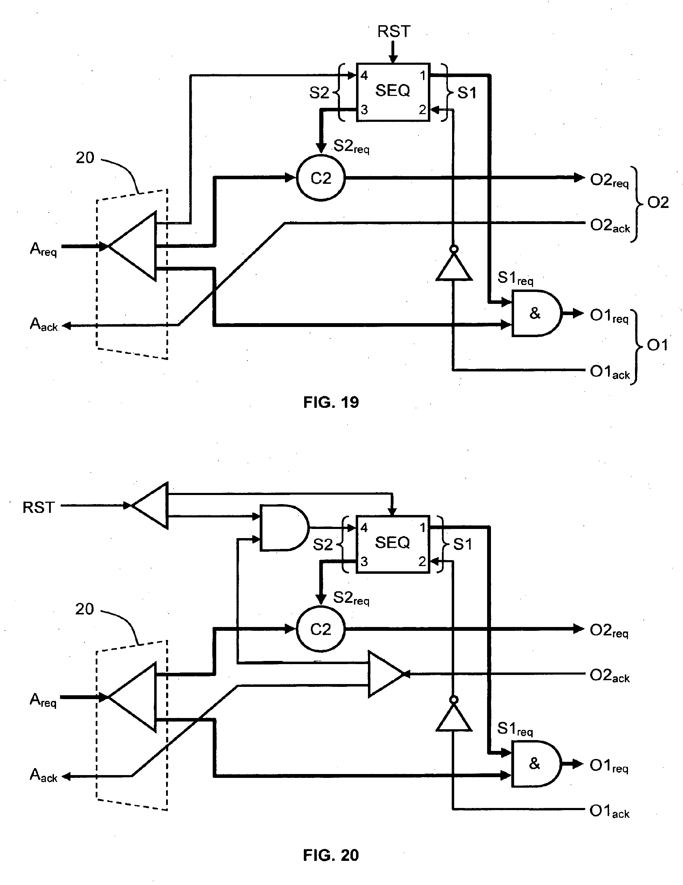

Les figures 19 et 20 représentent deux variantes de mise en oeuvre de la commande du séquenceur SEQ.

A l'inverse du cas précédent, le séquenceur SEQ de la figure 19 est commandé de façon automatique. Le canal de commande S2 est couplé directement au canal d'entrée A. Plus particulièrement, l'entrée 4 du séquenceur SEQ reçoit le signal de requête A_{req}. Cela peut être réalisé en prévoyant une sortie supplémentaire dans l'opérateur de divergence 20, comme cela est représenté.

Ainsi, à la première phase de fonctionnement, le signal de requête A_{req} = '1' se propage en aval de l'opérateur 20 dans les canaux intermédiaires O1, O2 et démarre simultanément la séquence d'écriture. On s'affranchit ainsi du circuit auxiliaire de contrôle et de son signal de commande C_{req}.

On remarque alors qu'il n'est plus nécessaire de faire reboucler le signal d'acquittement O2_{ack} vers le séquenceur pour démarrer une nouvelle séquence d'écriture. Un nouveau cycle commence avec une nouvelle requête A_{req} = '1' du canal d'entrée, celle-ci ne pouvant intervenir qu'après un acquittement O2_{ack} du dernier canal intermédiaire.

La figure 20 illustre un autre mode de commande du séquenceur, à mi-chemin entre les deux modes précédents. Il pourrait être qualifié de semi-automatique.

Le signal d'acquittement O2_{ack} du dernier canal intermédiaire est rebouclé sur le canal de commande S2 du séquenceur principal SEQ, par l'intermédiaire d'une porte « ET » supplémentaire.

La sortie de la porte « ET » est connectée à l'entrée 4 du séquenceur SEQ. En entrée, elle reçoit un signal de réinitialisation RST, en plus du signal d'acquittement O2_{ack} du dernier canal intermédiaire.

De préférence, le signal de réinitialisation RST est celui utilisé pour le séquenceur SEQ. Il est donc dupliqué en entrée du séquenceur SEQ (Fig.20).

On prévoit ainsi plusieurs techniques pour contrôler le séquenceur principal SEQ. Ces techniques peuvent être utilisées conjointement dans un même circuit asynchrone, mais pour des connexions de canaux différentes. Elles peuvent en outre être combinées avec n'importe quel mode de réalisation du circuit de mémorisation (Figs. 13, 17 et 18).

Une fois le signal RST relâché (RST = '1' : phase d'initialisation terminée), on constate que les variantes des figures 19 et 20 deviennent sensiblement équivalentes. Les séquences d'écritures s'enchaînent automatiquement, avec le signal O2_{ack} comme signal de départ dans un cas et avec le signal A_{req} dans l'autre cas. La variante avec le signal de requête A_{req} permet d'économiser une porte logique (la porte « ET » en entrée du séquenceur) mais elle est plus lente.

La variante des figures 13, 17 et 18 (avec le circuit auxiliaire de contrôle) remplit des fonctions complémentaires aux deux autres. Associée à l'une ou l'autre, elle permet, en pratique, de couvrir tous les cas de synthèse.

De nombreuses variantes et modifications du circuit à écritures séquentielles décrit ici apparaîtront à l'homme du métier. Le circuit peut notamment être réalisé avec d'autres implémentations du séquenceur, de l'opérateur de divergence ou de l'opérateur de converge.

A titre d'exemple, l'opérateur de divergence peut dupliquer ou diviser le canal d'entrée A en un nombre de canaux intermédiaires supérieur à 2. Dans ce cas, le séquenceur principal SEQ sera simplement muni d'un nombre plus important de canaux de commande, un par canal intermédiaire, de sorte que les requêtes des canaux intermédiaires convergent dans un ordre préétabli.

Alternativement, il peut être prévu plusieurs séquenceurs à au moins deux canaux de commande. Ces séquenceurs seront simplement commandés en décalé, de sorte qu'il n'y ait pas deux canaux intermédiaires connectés au canal de sortie au même instant.

Pour assurer le bon fonctionnement du circuit, il suffit de disposer dans le dernier canal intermédiaire de la séquence un interrupteur classique, tel qu'une porte de Müller, et dans tous les autres canaux (les premiers de la séquence) un circuit de mémorisation MEM, tel que ceux des figures 13, 17 et 18. Ainsi, chaque canal intermédiaire disposant d'un circuit MEM est assuré de terminer les quatre phases du protocole de communication son tour venu.

Enfin, bien qu'on ait représenté les signaux de requête des canaux par un seul fil sur les figures 13 à 20, ceux-ci peuvent être codés sur plusieurs bits (et donc véhiculés par plusieurs fils). C'est généralement le cas lorsque les données sont associées à la requête.

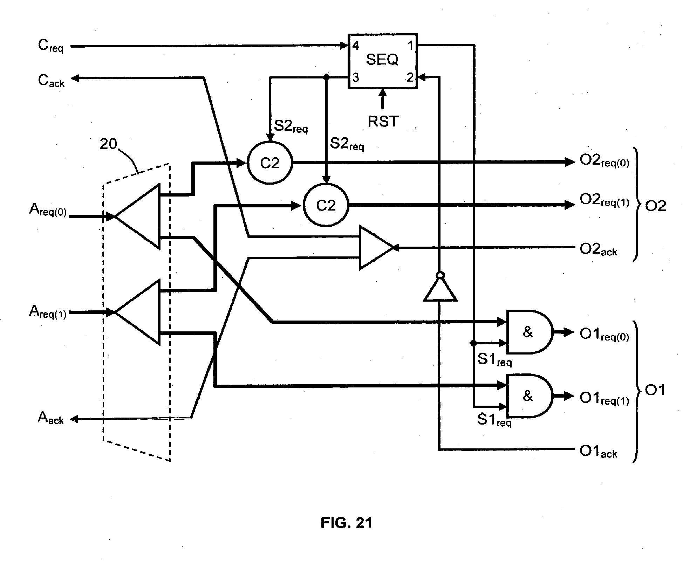

La figure 21 représente ce cas particulier, sur la base du circuit de la figure 18. La requête du canal d'entrée est, par exemple, codée sur deux bits A_{req(0)} et A_{req(1)}. Bien entendu, la requête du canal de sortie est également codée sur plusieurs bits et les écritures sont réalisées entre bit de même rang.

A chaque bit A_{req(0)} et A_{req(1)} est associé un opérateur de divergence 20, au moins deux canaux intermédiaires 01 et 02 (respectivement O1_{req(0)}, O1_{req(1)}, O2_{req(0)}, O2_{req(1)}) - l'un avec un circuit de mémorisation (porte & par exemple) et l'autre avec un interrupteur C2 - et un opérateur de convergence (non représenté).

Le séquenceur peut être commun à tous les fils de requête, comme cela est représenté sur la figure 21, en dupliquant les signaux de requête S1_{req} et S2_{req} des canaux de commande. Par exemple, les deux portes & reçoivent chacune un signal de requête S1_{req} et sur les deux portes de Müller C2 reçoivent chacune un signal de requête S2_{req}.

On pourrait également prévoir plusieurs séquenceurs, par exemple un par bit du signal de requête A_{req(0)} etA_{req(1)}.

## Revendications

1. Circuit asynchrone comprenant une pluralité de composants reliés par des canaux, chaque canal acheminant un signal de requête et un signal d'acquittement, **caractérisé en ce qu'il** comporte :
- un canal d'entrée (A_{req}, A_{ack}) ;
- un opérateur de divergence (20) connectant le canal d'entrée à une pluralité de canaux intermédiaires (O1_{req}, O1_{ack} ; O2_{req}, O2_{ack}) ;
- un opérateur de convergence (22) regroupant les canaux intermédiaires en un seul canal de sortie (Z) ;
- un séquenceur principal (SEQ) comprenant une pluralité de canaux de commande (S1 ; S2) activés séquentiellement, chaque canal intermédiaire étant couplé à un canal de commande ;
- un interrupteur (C2) disposé dans le chemin de requête de l'un des canaux intermédiaires et connecté au canal de commande (S2) activé en dernier, d'où il résulte que le signal de requête (O2_{req}) dudit canal intermédiaire est transmis vers le canal de sortie en dernier dans la séquence ;
- un circuit de mémorisation (MEM), disposé dans chacun des autres canaux intermédiaires (O1_{req}, O1_{ack}), connecté au canal de commande associé (S1) et configuré pour transmettre le signal de requête (O1_{req}) du canal intermédiaire associé vers le canal de sortie ; et
- le circuit de mémorisation (MEM) étant en outre configuré pour modifier l'état en sortie du canal intermédiaire associé (O1_{req}, O1_{ack}), au moyen du séquenceur principal, sans que le canal d'entrée (A_{req}, A_{ack}) ne change d'état.

2. Circuit asynchrone selon la revendication 1, dans lequel l'interrupteur (C2) est formé d'une porte de Müller recevant en entrée le signal de requête (O2_{req}) du canal intermédiaire associé et le signal de requête (S2_{req}) du canal de commande associé.

3. Circuit asynchrone selon l'une des revendications 1 et 2, dans lequel le circuit de mémorisation comporte une porte ET (&) recevant en entrée le signal de requête (O1_{req}) du canal intermédiaire associé et le signal de requête (S1_{req}) du canal de commande associé.

4. Circuit asynchrone selon l'une des revendications 1 et 2, dans lequel le circuit de mémorisation comporte une porte de Müller asymétrique (Cₐ) munie d'une première entrée recevant le signal de requête (O1_{req}) du canal intermédiaire associé et d'une deuxième entrée recevant le signal de requête (S1_{req}) du canal de commande associé, la première entrée ne conditionnant qu'une seule des transitions de la porte de Müller.

5. Circuit asynchrone selon l'une des revendications 1 et 2, dans lequel le circuit de mémorisation comporte :
- une porte de Müller (C1) recevant en entrée le signal de requête (O1_{req}) du canal intermédiaire associé et le signal de requête (S1_{req}) du canal de commande associé du séquenceur principal (SEQ) ; et
- un séquenceur secondaire (SEQ') muni d'un premier canal de commande (S1') couplé à la sortie du canal intermédiaire associé (O1_{req}, O1_{ack}) par l'intermédiaire de la porte de Müller (C1) et d'un second canal de commande (S2') couplé à l'entrée du canal intermédiaire associé (O1_{req}, O1_{ack}).

6. Circuit asynchrone selon l'une quelconque des revendications 1 à 5, dans lequel le canal de commande (S2) du séquenceur principal (SEQ) activé en dernier reçoit un signal de requête (C_{req}) d'un circuit de contrôle.

7. Circuit asynchrone selon l'une quelconque des revendications 1 à 5, dans lequel le canal de commande (S2) du séquenceur principal (SEQ) activé en dernier reçoit le signal de requête (A_{req}) du canal d'entrée.

8. Circuit asynchrone selon l'une quelconque des revendications 1 à 5, dans lequel le canal de commande (S2) du séquenceur principal (SEQ) activé en dernier reçoit le signal d'acquittement (O2_{ack}) du canal intermédiaire associé et un signal de réinitialisation (RST) du séquenceur.

## Patentansprüche

1. Asynchrone Schaltung, die eine Mehrzahl Komponenten aufweist, die über Kanäle miteinander verbunden sind, wobei jeder Kanal ein Anforderungssignal und ein Quittungssignal befördert, **dadurch gekennzeichnet, dass** sie umfasst:
- einen Eingangskanal (A_{req}, A_{ack});
- einen Divergenzrechner (20), der den Eingangskanal an eine Mehrzahl Zwischenkanäle (O1_{req}, O1_{ack}; O2_{req}, O2_{ack}) legt;
- einen Konvergenzrechner (22), der die Zwischenkanäle zu einem einzigen Ausgangskanal (Z) bündelt;
- einen Hauptsequenzer (SEQ), der eine Mehrzahl von Steuerkanälen (S1; S2) umfasst, die sequenziell aktiviert werden, wobei jeder Zwischenkanal an einen Steuerkanal gekoppelt ist;
- einen Schalter (C2), der auf dem Anforderungsweg eines der Zwischenkanäle liegt und an den Steuerkanal (S2) geschaltet ist, der als letztes aktiviert wird, weshalb das Anforderungssignal (O2_{req}) des Zwischenkanals in der Sequenz als letztes zum Ausgangskanal übertragen wird;
- eine Speicherschaltung (MEM), die in jedem der anderen Zwischenkanäle (O1_{req}, O1_{ack}) angeordnet, mit dem zugehörigen Steuerkanal (S1) verbunden und so konfiguriert ist, dass sie das Anforderungssignal (O1r_{eq}) des zugehörigen Zwischenkanals zum Ausgangskanal überträgt; und
- die Speicherschaltung (MEM) außerdem so konfiguriert ist, dass sie den Zustand des zugehörigen Zwischenkanals (O1_{req}, O1_{ack}) mit Hilfe des Hauptsequenzers verändert, ohne dass der Zustand des Eingangskanals (A_{req}, A_{ack}) sich ändert.

2. Asynchrone Schaltung nach Anspruch 1, bei der der Schalter (C2) von einem Müller-C-Element gebildet wird, das am Eingang das Anforderungssignal (O2_{req}) des zugehörigen Zwischenkanals und das Anforderungssignal (S2_{req}) des zugehörigen Steuerkanals empfängt.

3. Asynchrone Schaltung nach einem der Ansprüche 1 und 2, bei der die Speicherschaltung ein UND-Gatter (&) umfasst, das am Eingang das Anforderungssignal (O1_{req}) des zugehörigen Zwischenkanals und das Anforderungssignal (S1_{req}) des zugehörigen Steuerkanals empfängt.

4. Asynchrone Schaltung nach einem der Ansprüche 1 und 2, bei der die Speicherschaltung ein asymmetrisches Müller-C-Element (Cₐ) umfasst, das mit einem ersten Eingang versehen ist, der das Anforderungssignal (O1_{req}) des zugehörigen Zwischenkanals empfängt, sowie einem zweiten Eingang, der das Anforderungssignal (S1_{req}) des zugehörigen Steuerkanals empfängt, wobei der erste Eingang nur für einen einzigen der Übergänge des Müller-C-Elements zuständig ist.

5. Asynchrone Schaltung nach einem der Ansprüche 1 und 2, bei der die Speicherschaltung umfasst:
- ein Müller-C-Element (C1), das am Eingang das Anforderungssignal (O1_{req}) des zugehörigen Zwischenkanals und das Anforderungsignal (S1_{req}) des zugehörigen Steuerkanals des Hauptsequenzers (SEQ) empfängt, und
- einen Zweitsequenzer (SEQ'), der mit einem ersten Steuerkanal (S1') ausgestattet ist, der mittels des Müller-C-Elements (C1) und eines zweiten, an den Eingang des zugehörigen Zwischenkanals (O1_{req}, O1_{ack}) gekoppelten Steuerkanals (S2') mit dem Ausgang des zugehörigen Zwischenkanals (O1_{req}, O1_{ack}) gekoppelt ist.

6. Asynchrone Schaltung nach einem der Ansprüche 1 bis 5, bei der der Steuerkanal (S2) des zuletzt aktivierten Hauptsequenzers (SEQ) ein Anforderungssignal (C_{req}) einer Steuerschaltung empfängt.

7. Asynchrone Schaltung nach einem der Ansprüche 1 bis 5, bei der der Steuerkanal (S2) des zuletzt aktivierten Hauptsequenzers (SEQ) das Anforderungssignal (A_{req}) vom Eingangskanal empfängt.

8. Asynchrone Schaltung nach einem der Ansprüche 1 bis 5, bei der der Steuerkanal (S2) des zuletzt aktivierten Hauptsequenzers (SEQ) das Quittungssignal (O2_{ack}) des zugehörigen Zwischenkanals und ein Reinitialisierungssignal (RST) des Sequenzers empfängt.

## Claims

1. An asynchronous circuit comprising a plurality of components connected by channels, each channel conveying a request signal and an acknowledgement signal, **characterized in that** it comprises:
- an input channel (A_{req}, A_{ack}) ;
- a divergence operator (20) connecting the input channel to a plurality of intermediate channels (O1_{req}, O1_{ack} ; O2_{req}, O2_{ack}) ;
- a convergence operator (22) gathering the intermediate channels in a single output channel (Z);
- a main sequencer (SEQ) comprising a plurality of sequentially-activated control channels (S1 ; S2), each intermediate channel being associated to a control channel;
- a switch (C2) arranged in a request path of one of the intermediate channels, and connected to the last active control channel (S2), whereby a transmission of the request signal (O2_{req}) of said intermediate channel to the output channel occurs last in the sequence; and
- a memory circuit (MEM), arranged in each of the other intermediate channels (O1_{req}, O1_{ack}),, connected to the associated control channel (S1) and configured to transmit the request signal (O1_{req}) from the associated intermediate channel to the output channel; and
- the memory circuit (MEM) being further configured to modify an output state of the associated intermediate channel (O1_{req}, O1_{ack}), by means of the main sequencer, without requiring any state change of the input channel (A_{req}, A_{ack}).

2. The asynchronous circuit according to claim 1, wherein the switch (C2) is formed of a Muller C-element receiving as inputs the request signal (O2_{req}) of the associated intermediate channel and the request signal (S2_{req}) of the associated control channel.

3. The asynchronous circuit according to claims 1 and 2, wherein the memory circuit comprises an AND gate receiving as inputs the request signal (O1_{req}) of the associated intermediate channel and the request signal (S1_{req}) of the associated control channel.

4. The asynchronous circuit according to claims 1 and 2, wherein the memory circuit comprises an asymmetrical Muller C-element (Cₐ) provided with a first input receiving the request signal (O1_{req}) of the associated intermediate channel and with a second input receiving the request signal (S1_{req}) of the associated control channel, the first input conditioning only one of the transitions of the asymmetrical Muller C-element.

5. The asynchronous circuit according to claims 1 and 2, wherein the memory circuit comprises:
- a Muller C-element (C1) receiving as inputs the request signal (O1_{req}) from the associated intermediate channel and the request signal (S1_{req}) from the associated control channel of the main sequencer (SEQ); and
- a secondary sequencer (SEQ') provided with a first control channel (S1') coupled to an output of the associated intermediate channel (O1_{req}, O1_{ack}) via the Muller C-element (C1) and with a second control channel (S2') coupled to an input of the associated intermediate channel (O1_{req}, O1_{ack}).

6. The asynchronous circuit according to any one of claims 1 to 5, wherein the last active control channel (S2) of the main sequencer (SEQ) receives a request signal (C_{req}) from a control circuit.

7. The asynchronous circuit according to any one of claims 1 to 5, wherein the last active control channel (S2) of the main sequencer (SEQ) receives the request signal (A_{req}) of the input channel.

8. The asynchronous circuit according to any one of claims 1 to 5, wherein the last active control channel (S2) of the main sequencer (SEQ) receives the acknowledgement signal (O2_{ack}) of the associated intermediate channel and a signal for resetting (RST) the sequencer.
